Europäisches Patentamt

(19) European Patent Office

Office européen des brevets

(11) Publication number: **0 035 390**
**B1**

# EUROPEAN PATENT SPECIFICATION

(45) Date of publication of patent specification: **19.09.84**

(51) Int. Cl.³: **H 01 L 23/36**

(21) Application number: **81300835.6**

(22) Date of filing: **27.02.81**

(54) A semiconductor integrated circuit device with an improved heat sink.

(30) Priority: **29.02.80 JP 24689/80**

(43) Date of publication of application:
**09.09.81 Bulletin 81/36**

(45) Publication of the grant of the patent:
**19.09.84 Bulletin 84/38**

(84) Designated Contracting States:
**DE FR GB NL**

(56) References cited:
**CH-A- 416 844**
**DE-A-2 607 403**
**DE-B-2 749 848**
**DE-U-1 773 097**
**GB-A-1 172 648**
**US-A-4 034 468**

**IBM TECHNICAL DISCLOSURE BULLETIN, Vol.
21, No. 3, August 1978 New York R.D. DURAND
et al. "Ceramic Cap and Heat Sink for
Semiconductor Package"**
**IBM TECHNICAL DISCLOSURE BULLETIN, Vol.
21, No. 7, December 1978 New York G.
DUMAINE et al. "Circuit Package"**

(73) Proprietor: **FUJITSU LIMITED**
**1015, Kamikodanaka Nakahara-ku
Kawasaki-shi Kanagawa 211 (JP)**

(72) Inventor: **Wakabayashi, Tetsushi
18-406 Asodaidanchi 861-2, Shimoaso Tama-ku
Kawasaki-shi Kanagawa 215 (JP)**
Inventor: **Honda, Norio
21-4,Aza Miyashita Oaza Kamiarakuda
Machikitamachi
Aizuwakamatsu-shi Fukushima 965 (JP)**
Inventor: **Sakuma, Osamu
2-2-5, Edakita Midori-ku
Yokohama-shi Kanagawa 227 (JP)**

(74) Representative: **Abbott, Leonard Charles et al
GILL JENNINGS & EVERY 53-64 Chancery Lane
London WC2A 1HN (GB)**

(56) References cited:
**IBM TECHNICAL DISCLOSURE BULLETIN, Vol.
22, No. 6, November 1979 New York A.J.
ARNOLD et al. "Heat Sink Design for Cooling
Modules in a Forced Air Environment"**

Courier Press, Leamington Spa, England.

## Description

The present invention relates to a semiconductor device, and more particularly to a semiconductor device which has a plurality of IC (Integrated Circuit) packages mounted on a mother board and which has an improved heat sink structure.

There is known a semiconductor device having a multi-package structure in which a plurality of IC packages are mounted on a single mother board. The multi-package structure has an advantage, for example, that it enables a high integration degree of the semiconductor device.

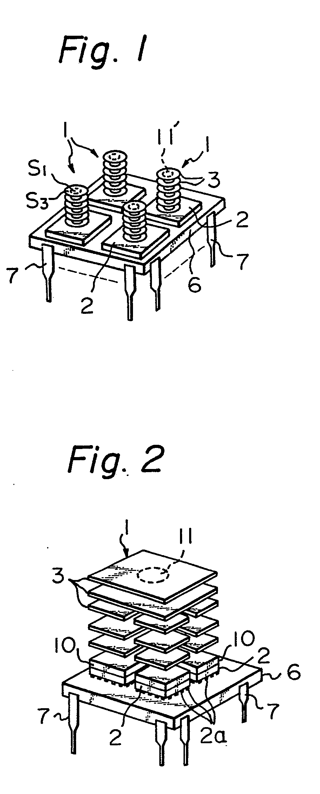

Fig. 1 illustrates such a semiconductor device having the multi-package structure and also with heat sinks in accordance with the invention of our divisional European patent application No. 0 054 539. This device comprises four IC packages 2 adjacently mounted on a single mother board 6. A plurality of pin terminals 7 are attached to the edges of the mother board 6 and are connected to the IC packages 2 through a multilayer interconnection buried within the mother board 6. On each of the IC packages 2, a heat sink 1 comprising a heat conducting shaft portion 11' and heat dissipating fins 3 is respectively arranged. Each of the heat dissipating fins 3 has, for example, a round shape and has a smaller size than that of the outward form of each of the IC packages 2.

However, in the above-mentioned semiconductor device a number of heat sinks 1 are mounted within a small area, so that the space between each of the heat sinks 1 becomes very small. Therefore, cooling air cannot flow smoothly and the cooling effect of the heat sinks 1 is decreased. Moreover, since the cooling air is supplied from a predetermined direction to the heat sinks 1, the cooling effect of the heat sinks 1 disposed on the lee becomes worse than that of the heat sinks 1 disposed on the windward side. In order to increase the cooling effect of the heat sinks 1, it is generally necessary, for example, to increase the area of each of the heat dissipating fins 3. However, it is difficult to increase the area of each of the heat dissipating fins 3, because the size of each of the heat dissipating fins 3 must be smaller than that of the outward form of each of the IC packages 2. If the size of each of the heat dissipating fins 3 is approximately equal to or larger than that of each of the IC packages 2 which are adjacently disposed on the mother board 6, it is difficult to mount the IC packages 2, to which the heat dissipating fins 3 are attached, on the mother board 6 in the manufacturing process of the semiconductor device. Moreover, the size of each of the IC packages 2 has become smaller with the recent increase in the packing density of the semiconductor device so that the junction area between each of the heat sinks 1 and the corresponding one of the IC packages 2 becomes small. Therefore, the mechanical strength between the IC packages 2 and the heat sinks 1 is decreased and the semiconductor device must be handled very carefully.

There has also been disclosed in IBM Technical Disclosure Bulletin, Vol. 21, No. 7, December 1978, page 2852, a circuit package in which semiconductor devices are joined to a carrier substrate which is in turn connected to the base board of a heat sink, from which base board extend parallel fins. IBM Technical Disclosure Bulletin Vol. 21, No. 3, August 1978, pages 1064 and 1065, disclose a generally similar heat sink contacting semiconductor devices through thermal grease or foil. Other heat sinks having heat dissipating fins extending from a central shaft are known from British Patent Specification No. 1172648 and the German Utility Model Specification No. 1773097.

The present invention consists in a semiconductor package including a plurality of IC packages mounted on a carrier board and a heat sink having a base board and a plurality of heat dissipating fins connected to the base board with good thermal conductivity, characterized in that the heat sink is joined either in common to the IC packages or to the carrier board, and in that the heat sink is formed with one or more slits which extend from the base board in a direction perpendicular to the base board, the heat sink being joined to the IC packages or to the carrier board at sections of the base board divided by the said one or more slits.

In one form, using the type of heat sink in which a heat-conducting shaft extends from the base board and heat dissipating fins are mounted on the shaft, two mutually perpendicular slits are formed across the common heat sink, intersecting at the axis of the shaft. In another form, using a heat sink of the kind in which the heat dissipating fins are perpendicular to the base board and parallel to each other, each fin has a plurality of slits spaced along its length. The provision of such slits dividing the base board into sections, allows the base board of the heat sink to move, thereby reducing the thermal stress between each IC package and its carrier board portion.

In order that the invention may be better understood, two embodiments of the invention will now be described with reference to the accompanying drawings, in which:—

Figure 1, to which reference has been made already, is a perspective view illustrting a semiconductor device having a multi-package structure and also with heat sinks in accordance with the invention of our divisional European patent application No. 0 054 539.

Figure 2 is a perspective view illustrating a semiconductor device having a multi-package structure and having an improved, novel heat sink structure according to a first embodiment of the present invention;

Figure 3 is a partially cutaway plan view of the semiconductor device of Figure 2;

Figure 4 is a cross sectional view taken on line IV—IV of Figure 3;

Figure 5 is a graph illustrating characteristics of a heat sink structure used in the semiconductor device according to the present invention in comparison with that of the heat sink structure used in the conventional semiconductor device;

Fig. 6A is a perspective view illustrating another embodiment of the present invention, and;

Fig. 6B is an elevational view of the embodiment illustrated in Fig. 6A.

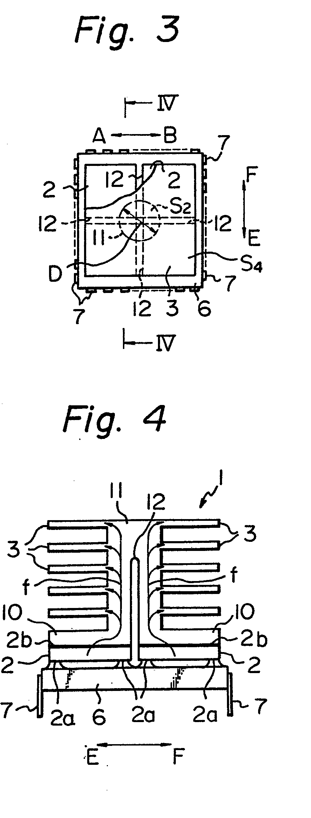

As illustrated in Fig. 2, the first embodiment of the present invention comprises a square shaped mother board 6 within which printed circuit patterns having a multi-layer structure are formed. A plurality of pin terminals 7 are attached to the four edges of the mother board 6 to each of the pin terminals 7 is electrically connected to the printed circuit within the mother board 6 appropriately. On the mother board 6, four IC packages 2 are mounted. Each of the IC packages 2 contains a semiconductor element therein and has a plurality of bonding pads 2a at the base thereof which are electrically connected to the semiconductor element. Each of the bonding pads 2a is bonded to a corresponding one of printed circuit patterns which are formed on the mother board 6 under the bonding pads 2a and which are connected to the printed circuit patterns formed within the mother board 6. The semiconductor device according to the present invention further comprises a common heat sink 1 whose base board portion 10 is adhered to the four IC packages 2 by using, for example, epoxy adhesive agent or by means of brazing. As also illustrated in Figs. 3 and 4, the heat sink 1 which is made of materials having high thermal conductivity such as aluminum comprises a cylindrical heat conducting shaft portion 11 and which has a diameter D and which is arranged perpendicular to the base board portion 10 at the center thereof. A plurality of heat dissipating fins 3 are arranged around the heat conducting shaft portion 11 at a constant distance and in parallel with each other. Each of the heat dissipating fins 3 is a thin board having approximately a square shape. It should be noted that the thickness of the base board portion 10, which has approximately the same shape as that of each of the heat dissipating fins 3, is larger than the thickness of each of the heat dissipating fins 3, in order to lower the thermal resistance from the IC packages 2 to the heat conducting shaft 11. The heat sink 1 has two slits 12, 12 which are formed parallel to the heat conducting shaft 11 from the base board portion 10 to midway in the heat conducting shaft 11 and which divide the base board portion 10, a part of the heat dissipating fins 3 and a part of the heat conducting shaft 11 into four sections.

When the above-mentioned semiconductor device is operated, each of the IC packages 2 generates heat due to the heat generation from the semiconductor element mounted within the IC package. The heat generated from each of the IC packages 2 is transferred, as shown by lines with arrows f in Fig. 4, from the top surfaces 2b of the IC packages 2 through the base board portion 10 of the heat sink 1 to the heat conducting shaft 11. Since the heat conducting shaft 11 is made of materials having high thermal conductivity the heat conducting shaft 11 is heated up so that the temperature distribution is approximately the same throughout the whole length of the heat conducting shaft 11. The heat delivered to the heat conducting shaft 11 is further transferred from the heat conducting shaft 11 to each of the heat dissipating fins 3 and dissipated into the surrounding air.

The quantity of heat dissipated from the heat sink 1 is greatly influenced by a diameter D of the heat conducting shaft 11 which is a parameter of heat conducting area of the heat conducting shaft 11 and by a heat dissipating area of one of the heat dissipating fins 3 which is a parameter of a total heat dissipating area of the heat sink 1. Generally, the quantity of the heat dissipated from the heat sink 1 becomes large in accordance with the increase in the above-mentioned diameter D and in the above-mentioned heat dissipating area. However, the outward size of the heat sink 1 is limited to a constant size by the size of the mother board 6 and each of the IC packages 2 and by the surroundings of the semiconductor device and so on. Assume that the sizes of the mother boards and the sizes of the IC packages of both the semiconductor device according to the present invention and the semiconductor device of Figure 1 are the same as each other. In this condition, since the semiconductor device in Fig. 1 comprises four heat conducting shafts 11', the ratio K of the cross sectional area of the semiconductor device according to the present invention to the cross sectional areas of the conventional semiconductor device becomes as follows.

$$K = \frac{S_2}{4S_1} = \frac{\pi}{4S_1} \left(\frac{D}{2}\right)^2 \qquad (1)$$

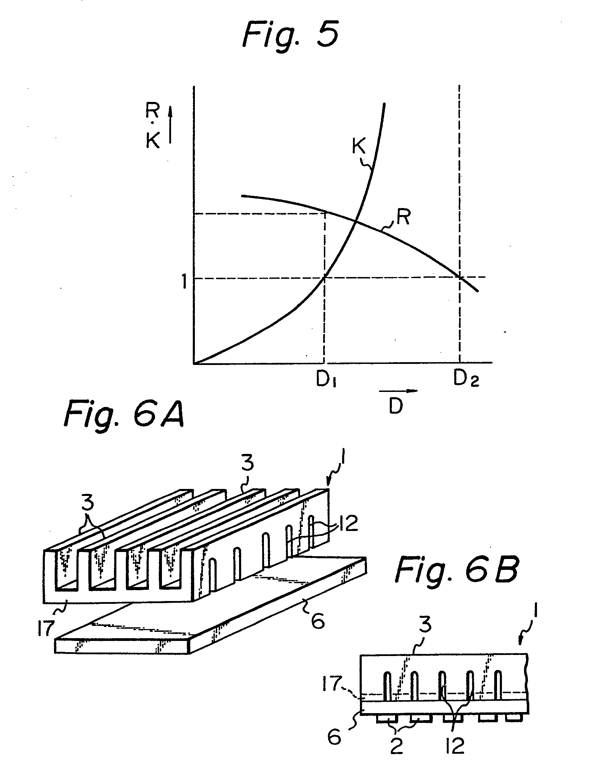

Where $S_1$ designates the heat conducting area, i.e., the cross sectional area of each of the heat conducting shafts 11' of the heat sinks 1 of the semiconductor device in Fig. 1, and $S_2$ designates the cross sectional area of the heat conducting shaft 11 of the semiconductor device according to the present invention. The characteristic of the ratio K with regard to the diameter D is shown in Fig. 5.

When the same number of heat dissipating fins 3 are arranged parallel to each other, being provided with the heat conducting shafts 11 and 11', the ratio R of the heat dissipating area of the heat sink 1 of the semiconductor device according to the present invention to the heat dissipating area of the heat sinks 1 of the conventional semiconductor device becomes as follows.

$$R = \frac{S_4}{4S_3} = \frac{S_0 - S_2}{4S_3} = \frac{S_0 - \pi(D/2)^2}{4S_3} \quad (2)$$

Where $S_3$ is one side area of each of the heat dissipating fins 3 of the conventional semiconductor device, $S_4$ is one side area of each of the heat dissipating fins 3 of the semiconductor device according to the present invention, and $S_0$ is one side area of each of the heat dissipating fins 3 including the cross sectional area of heat conducting shaft 11 of the semiconductor device according to the present invention. The characteristic of the ratio R with regard to the diameter D is also shown in Fig. 5.

As apparent from Fig. 5, when the cross sectional area $4S_1$ of the heat conducting shafts 11' of the conventional semiconductor device is equal to the cross sectional area $S_2$ of the heat conducting shaft 11 of the semiconductor device according to the present invention, i.e., when the ratio K is equal to 1, the diameter D is equal to $D_1$ and the ratio R is larger than 1. Therefore, the area $S_4$ of each of the heat dissipating fins 3 of the semiconductor device according to the present invention can be much larger than the area $4S_3$ of the heat dissipating fins 3 of the conventional semiconductor device. When the ratio R is equal to 1, the diameter D of the heat conducting shaft of the semiconductor device according to the present embodiment is equal to $D_2$ and the K of the cross sectional areas of the heat conducting shafts 11 and 11' is larger than 1. Therefore, in this case the cross sectional area $S_2$ of the heat conducting shaft of the semiconductor device according to the present invention can be larger than the cross sectional area $4S_1$ of the heat conducting shafts of the conventional semiconductor device. Therefore, there exists an optimum point of the diameter D of the heat conducting shaft 11 between the diameters $D_1$ and $D_2$ at which point the quantity of heat dissipated into the surrounding air becomes maximum. The optimum point can be selected, for example, through experiments by using several heat sinks having different areas $S_2$ and/or $S_4$. Consequently, it is possible to make up a semiconductor device whose cross sectional area $S_2$ of the heat conducting shaft and whose area $S_4$ of each of the heat dissipating fins are both larger than those of the conventional semiconductor device, so that the quantity of heat dissipated into the surrounding air from the semiconductor device according to the present invention is larger than that from the conventional semiconductor device.

When the semiconductor device is operated, the mother board 6 suffers thermal expansion in the direction shown by arrows A, B and E, F in Fig. 3 due to the heat up thereof. According to the thermal expansion of the mother board 6, each of the IC packages 2 which are coupled on the mother board 6 at the bonding pads 2a thereof deviates in the directions shown by the arrows A, B and E, F. Moreover, each of the IC packages 2 is fixed to the base board portion 10 of the heat sink 1 by using for example, epoxy adhesive agent, so that the heat sink 1 suffers forces which deviate every portion of the heat sink 1 in the direction shown by the arrows A, B and E, F. Since the heat sink 1 of the semiconductor device according to the present embodiment has the slits 12, 12 which divide the base board portion 10 of the heat sink 1 into sections each corresponding to one of the IC packages 2, the base board portion 10 of the heat sink 1 can easily move in the directions shown by the arrows A, B and E, F for distances corresponding to the deviation of each of IC packages 2, and the width of each of the slits 12, 12 increases or decreases in accordance with the deviation of each of the IC packages 2. Therefore, the thermal stress between each of the IC packages 2 and the base board portion 10 and between the mother board 6 and each of the IC packages 2 can be greatly reduced, so that the separation between the base board portion 10 and the upper surface of each of the IC packages 2 or between each of the IC packages 2 and the mother board 6 due to the thermal stress does not occur. There is a possibility of thermal stess occurring due to the difference of temperature expansion between the heat sink 1 and the IC packages 2 and between the IC packages 2 and the mother board 6, when the heat sink 1 is fixed on the IC packages 2, which are mounted on the mother board 6, by means of brazing in the manufacturing process of the semiconductor device. However, the above-mentioned thermal stress is also greatly reduced due to the existence of the slits 12, 12 of the heat sink 1. Therefore, the deformation or destruction of the mother board 6 or the generation of residue stress at the junction part of the heat sink 1 due to the thermal stress can be prevented.

In the above-mentioned embodiment, the semiconductor device comprises the mother board 6 which has many pin terminals 7 attached to the four edges thereof and on which four IC packages 2 are mounted. However, it should be noted that the present invention can be adapted, for example, to the semiconductor device comprising many IC packages 2 mounted on a large mother board 6 which does not have pin terminals 7, as illustrated in Fig. 6A and Fig. 6B. It is also possible to use the heat conducting portion which is formed as a heat conducting board portion 17 as illustrated in Fig. 6A and on which are arranged many heat dissipating fins 3. In the aforementioned embodiment illustrated in Figs. 2 through 4, the heat sink 1 is coupled with the mother board 6 via the IC packages 2 therebetween. However, the heat sink 1 can be coupled directly with the mother board 6 as illustrated in Fig. 6B, so long as the heat sink 1 is coupled to the mother board 6 at the plurality of sections of the heat sink 1 divided by the slits 12. In the embodiment of Figs. 6A and 6B, the heat conducting area of the heat conducting board portion 17 is equal to the area of the junction part between the heat conducting board portion 17 and the mother board 6. The heat conducting area of the heat conducting board portion 17 is apparently larger than that of the semiconductor device of Fig. 1 which comprises one heat sink on each of the IC packages 2. The area of the heat dissipating fins 3 can be much larger than that of the conventional semiconductor device. Therefore, the semiconductor device of Figs. 6A and 6B has a larger heat dissipating effect than that of the conventional semiconductor device.

As mentioned above, since the semiconductor device according to the present invention uses a single heat sink structure 1 comprising the heat conducting portion, such as the heat conducting shaft portion 11, and a plurality of heat dissipating fins 3 for each mother board 6 on which a plurality of IC packages 2 are mounted, the substantial heat dissipating area of the heat sink 1 used in the semiconductor device according to the present invention can be larger than that of the heat sinks 1 of the conventional semiconductor device, because in the present invention, the space between the heat sinks on the mother board 6 of the conventional semiconductor device can be used to expand the area of the heat dissipating fins 3. Furthermore, the cooling air can flow more smoothly through the heat sink 1, so the quantity of heat dissipated from the heat sink 1 on each mother board 6 can be greater than that of the conventional semiconductor device. Therefore, the heat sink structure of the semiconductor device according to the present invention shows a high cooling performance even when the semiconductor devices are mounted in high density. Since the heat sink 1 is coupled to the mother board 6 at a plurality of sections divided by the slits 12, the mechanical strength of the semiconductor device according to the present invention can be very large and the aforementioned thermal stress and the residual stress generated in the manufacturing process are greatly reduced due to the existence of the slits 12, so that the heat sink structure of the semiconductor device having high reliability can be provided.

## Claims

1. A semiconductor package including a plurality of IC packages (2) mounted on a carrier board (6) and a heat sink (1, Figures 4 and 6A) having a base board (10, Figure 4; 17, Figure 6) and a plurality of heat dissipating fins (3) connected to the base board with good thermal conductivity, characterized in that the heat sink (1) is joined either in common to the IC packages or to the carrier board, and in that the heat sink is formed with one or more slits (12) which extend from the base board (10, 17) in a direction perpendicular to the base board, the heat sink being joined to the IC packages or to the carrier board at sections of the base board divided by the said one or more slits.

2. A semiconductor device in accordance with claim 1 in which a heat-conducting shaft (11) is arranged approximately perpendicular to the base board and the heat dissipating fins (3) are mounted on the shaft, each being arranged approximately parallel to the base board, characterized in that the heat sink is joined in common to the plurality of IC packages (2) at its base board and in that the slits (12) extend through the shaft.

3. A semiconductor device in accordance with claim 2, wherein two mutually perpendicular slits (12) are formed across the common heat sink, the slits intersecting at the axis of the heat-conducting shaft (11).

4. A semiconductor device in accordance with claim 1, 2 or 3, wherein the heat sink is joined to the IC packages by an epoxy adhesive agent.

5. A semiconductor device in accordance with claim 1, 2 or 3 wherein the heat sink is joined to the IC packages by brazing the base board to the top surfaces of the IC packages.

6. A semiconductor device in accordance with any one of the preceding claims, wherein the base board is divided by the slits (12) into a number of sections equal to the number of IC packages mounted on the carrier board.

7. A semiconductor device in accordance with any preceding claim, wherein the base board is thicker than any of the heat dissipating fins.

8. A semiconductor device in accordance with claim 1, characterized in that the heat sink is mounted on the carrier board on a side opposite the side to which the IC packages are connected, and in that the heat dissipating fins (3) are arranged substantially perpendicular to the base board and parallel to each other, each fin having a plurality of slits spaced along its length.

9. A semiconductor device in accordance with any preceding claim, wherein the IC packages are coupled to the carrier board by bonding between bonding pads (2a) of the IC packages and printed circuit patterns on the carrier board.

## Patentansprüche

1. Halbleiterbaugruppe mit einer Anzahl von IC-Baugruppen (2), die auf einer Trägerplatte (6) montiert sind, und einer Wärmesenke (1, Figuren 4 und 6a), die eine Grundplatte (10, Figur 4; 17, Figur 6) und eine Anzahl von Kühlrippen (3) aufweist, die gut wärmeleitend mit der Grundplatte verbunden sind, dadurch gekennzeichnet, daß die Wärmesenke (1) entweder gemeinsam mit den IC-Baugruppen oder mit der Grundplatte verbunden ist, und daß die Wärmesenke einen oder mehrere Schlitze (12) aufweist, die sich von der Grundplatte (10, 17) in eine Richtung rechtwinklig zu der Grundplatte erstrecken und die Wärmesenke mit den IC-Baugruppen oder mit der Grundplatte an Abschnitten der Grundplatte verbunden ist, die durch den oder die gennannten Schlitze geteilt sind.

2. Halbleitervorrichtung nach Anspruch 1, bei welcher ein wärmeleitender Schaft (11) etwa rechtwinklig zu der Grundplatte angeordnet ist und die Kühlrippen (3) an dem Schaft jeweils etwa parallel zu der Grundplatte angeordnet, befestigt sind, dadurch gekennzeichnet, daß die Wärmesenke gemeinsam mit der Anzahl von IC-Baugruppen (2) an ihrer Grundplatte verbunden ist und daß die Schlitze (12) sich durch den Schaft erstrecken.

3. Halbleitervorrichtung nach Anspruch 2, bei welcher zwei wechselseitig zueinander rechtwinklige Schlitze quer über die gemeinsame Wärmesenke gebildet sind und die Schlitze sich bei der Achse des wärmeleitenden Schaftes (11) schneiden.

4. Halbleitervorrichtung nach Anspruch 1, 2 oder 3, bei welcher die Wärmesenke mittels eines Epoxidklebemittels an den IC-Baugruppen befestigt ist.

5. Halbleitervorrichtung nach Anspruch 1, 2 oder 3, bei welcher die Wärmesenke mit den IC-Baugruppen dadurch verbunden ist, daß die Grundplatte an die Oberflächen der IC-Baugruppen angelötet ist.

6. Halbleitervorrichtung nach einem der vorhergehenden Ansprüche, bei welcher die Grundplatte durch die Schlitze (12) in eine Anzahl von Abschnitten unterteilt ist, die gleich der Anzahl der auf der Grundplatte befestigten IC-Baugruppen ist.

7. Halbleitervorrichtung nach einem der vorhergehenden Ansprüche, bei welcher die Grundplatte dicker als irgendeine der Kühlrippen ist.

8. Halbleitervorrichtung nach Anspruch 1, dadurch gekennzeichnet, daß die Wärmesenke auf der Grundplatte auf der Seite angeordnet ist, die gegenüber der Seite ist, an der die IC-Baugruppen befestigt sind, und daß die Kühlrippen (3) im wesentlichen rechtwinklig zu der Grundplatte und parallel zueinander angeordnet sind und jede Rippe auf ihrer Länge eine Anzahl von Schlitzen aufweist.

9. Halbleitervorrichtung nach einem der vorhergehenden Ansprüche, bei welcher die IC-Baugruppen mit der Grundplatte durch Verbindung zwischen den Kontaktflächen (2a) der IC-Baugruppe und den gedruckten Schaltungsmustern auf der Trägerplatte gekoppelt sind.

**Revendications**

1. Un dispositif semiconducteur comprenant plusieurs boîtiers de CI (2) montés sur une plaquette de support (6) et un radiateur (1, figures 4 et 6A) ayant une plaquette de base (10, figure 4; 17, figure 6) et plusieurs ailettes de dissipation de chaleur (3) fixées à la plaquette de base avec une bonne conductivité thermique, caractérisé en ce que le radiateur (1) est accouplé soit en commun aux boîtiers de CI, soit à la plaquette de support, et en ce que le radiateur comporte une ou plusieurs fentes (12) qui s'étendent à partir de la plaquette de base (10,17) dans une direction perpendiculaire à la plaquette de base, et le radiateur est accouplé aux boîtiers de CI ou à la plaquette de support au niveau de sections de la plaquette de base qui sont séparées par la ou les fentes.

2. Un dispositif semiconducteur selon la revendication 1, dans lequel une tige de conduction de chaleur (11) est disposée en position approximativement perpendiculaire à la plaquette de base, et les ailettes de dissipation de chaleur (3) sont montées sur la tige, chacune d'elles étant disposée de façon approximativement parallèle à la plaquette de base, caractérisé en ce que la radiateur est accouplé en commun aux différents boîtiers de CI (2) au niveau de sa plaquette de base, et en ce que les fentes (12) traversent la tige.

3. Un dispositif semiconducteur selon la revendication 2, dans lequel deux fentes mutuellement prependiculaires (12) sont formées dans le radiateur commun, et les fentes sen rencontrent au niveau de l'axe de la tige de conduction de chaleur (11).

4. Un dispositif semiconducteur selon la revendication 1, 2 ou 3, dans lequel le radiateur est accouplé aux boîtiers de CI par un adhésif à base d'époxyde.

5. Un dispositif semiconducteur selon la revendication 1, 2 ou 3, dans lequel le radiateur est accouplé aux boîtiers de CI par brasage de la plaquette de base sur les surfaces supérieures de boîtiers de CI.

6. Un dispositif semiconducteur selon l'une quelconque des revendications précédentes, dans lequel la plaquette de base est divisée par les fentes (12) en un nombre de sections égal au nombre de boîtiers de CI montés sur la plaquette de support.

7. Un dispositif semiconducteur selon l'une quelconque des revendications précédentes, dans lequel la plaquette de base est plus épaisse que l'une quelconque des ailettes de dissipation de chaleur.

8. Un dispositif semiconducteur selon la revendication 1, caractérisé en ce que le radiateur est monté sur la plaquette de support du côté opposé au côté sur lequel les boîtiers de CI sont connectés, et en ce que les ailettes de dissipation de chaleur (3) sont disposées de façon pratiquement perpendiculaire à la plaquette de base, et parallèlement les unes aux autres, chaque ailette comportant plusieurs fentes espacées dans la direction de sa longueur.

9. Un dispositif semiconducteur selon l'une quelconque des revendications précédentes, dans lequel les boîtiers de CI sont fixés à la plaquette de support par soudage de plots de soudage (2a) des boîtiers de CI sur des pistes de circuit imprimé de la plaquette de support.

# Fig. 1

# Fig. 2

# Fig. 3

# Fig. 4

# Fig. 5

# Fig. 6A

# Fig. 6B